# EUROPEAN PATENT SPECIFICATION

(11) **EP 0 713 007 B1**
(45) Date of publication and mention of the grant of the patent: **11.11.1998**
(21) Application number: 95120747.1
(22) Date of filing: 30.11.1992
(51) Int. Cl.: F02P 17/00, G01R 15/06, G01R 31/00

(54) **A spark plug voltage probe device for an internal combustion engine**
Spannungstester für Zündkerzen in einer Brennkraftmaschine
Testeur de potentiel de bougie d'allumage dans un moteur à combustion interne

(30) Priority: 28.11.1991 JP 314783/91; 29.11.1991 JP 316685/91; 11.05.1992 JP 117683/92; 13.11.1992 JP 303859/92
(43) Date of publication of application: 22.05.1996
(62) Divisional of application: 92310909.4
(73) Proprietor: NGK SPARK PLUG CO., LTD, Nagoya-shi (JP)
(72) Inventor: Miyata, Shigeru, c/o NGK Spark Plug Co. Ltd., Nagoya-shi (JP); Yoshida, Hideji, c/o NGK Spark Plug Co. Ltd., Nagoya-shi (JP); Yamada, Yoshitaka, c/o NGK Spark Plug Co. Ltd., Nagoya-shi (JP); Ito, Yasuo, c/o NGK Spark Plug Co. Ltd., Nagoya-shi (JP); Matsubara, Yoshihiro, c/o NGK Spark Plug Co. Ltd., Nagoya-shi (JP)
(74) Representative: Senior, Alan Murray

(56) References cited:
- EP-A- 0 032 647
- EP-A- 0 134 742
- GB-A- 2 116 329
- US-A- 4 090 130
- US-A- 5 001 431

## Description

This invention relates to a probe for the detection of voltages applied to spark plugs to detect faulty firing in an internal combustion engine.

With the demand of purifying emission gas and enhancing fuel efficiency of internal combustion engines, it has been necessary to detect the firing condition in each cylinder of the internal combustion engine so as to protect the internal combustion engine plug against misfire. In order to detect the firing condition in each of the cylinders it is known to install an optical sensor within the cylinders. Alternatively, it is also known to attach a piezoelectrical sensor to a seat pad of each spark plug.

Using the prior art, it is troublesome and time-consuming to install a sensor for each of the cylinders, thus increasing the installation cost, and at the same time, taking up a lot time to check and in maintenance.

Document GB-A-2,116,329, upon which disclosure the preamble of claim 1 is based, describes a system for recognising misfirings on the basis of voltage change signals in a capacitance formed between spark plug cables placed in open-topped grooves and a correspondingly corrugated electrode plate.

It is one of the objects of the invention to provide a spark plug voltage probe device for an internal combustion engine which is capable of detecting a voltage applied to the spark plug of each cylinder of the internal combustion engine precisely with a relatively simple structure.

According to the present invention, there is provided a spark plug voltage probe device for attachment to an internal combustion engine and for detecting a voltage applied to spark plugs installed in the internal combustion engine by way of corresponding cables, the device comprising:
an insulator base having a plurality of grooves in which the corresponding cables are to be placed;
an electrode layer embedded in the insulator base along the grooves to form a static capacitance between the electrode layer and placed cables when the voltage is supplied across the spark plugs;
a lead wire provided for electrically connecting the electrode layer to a microcomputer so as to analyse the burning condition in the internal combustion engine on the basis of the voltage applied to each of the spark plugs; characterised in that
said insulator base includes an upper half and a lower half which are integrally connected by means of a pivot portion, both said upper half and said lower half providing said grooves for holding said corresponding cables when the two halves are folded together about the pivot portion; in that
the upper half has an opening which admits an entry of a protrusion which is provided on the lower half to maintain the upper half and the lower half in a folded position; and in that
said electrode layer is embedded in both said upper and lower halves.

According to the invention, a substantially uniform static capacitance is formed between the insulator base and spark plug cables which is sufficient to detect a spark plug voltage in each of the cylinders in the combustion engine using the single spark plug voltage probe device.

Advantageously, an electrical shield sheet may be used to make it is possible to prevent a static capacitance from occurring between the electrode layer and the periphery of the engine when the device is mounted on an engine, thus avoiding sensitivity variation of the spark plug voltage probe device depending on where the probe device is mounted.

According further to the invention, a substantially uniform static capacitance may be formed between each of spark plug cables and corresponding grooves of the electrode layer, so that a substantially constant level of spark plug voltage is obtained in each cylinder of the internal combustion engine, thus making it possible to detect a burning condition in the internal combustion engine precisely.

An adhesive filler may be provided between the upper half and the lower half of the insulator base, thus preventing entry of water into the insulator base and avoiding capacitance changes between the spark plug cables and the electrode layer, so as to prevent faulty voltages from being detected by the probe device.

The present invention may be further understood from the following description, meant by way of example only, with reference to the accompanying drawings, in which:
Fig. 1 is a perspective exploded view of a first spark plug voltage probe device useful in explaining the present invention;
Fig. 2 is a perspective view of the spark plug voltage probe device of Fig. 1;
Fig. 3 is a perspective view with the spark plug voltage probe device of Fig. 1 mounted on an internal combustion engine;
Fig. 4 is a schematic view of an ignition system incorporated into an internal combustion engine;
Fig. 5 is a view similar to Fig. 1 according to a second non-embodiment of the invention;
Fig. 6 is a view similar to Fig. 1 according to a third non-embodiment of the invention;
Fig. 7 is view similar to Fig. 1 according to a fourth non-embodiment of the invention;
Fig. 8 is a perspective view of a spark plug voltage probe device with an upper half and a lower half in a folded position, according to a first embodiment of the invention;
Fig. 9 is a perspective view of the spark plug voltage probe device of Fig. 8 with the upper half and the lower half in an open position;
Fig. 10 is a perspective view of the spark plug voltage probe device of Fig. 8 with spark plug cables located in grooves;
Fig. 11 is a view similar to Fig. 3 according to the first embodiment of the invention;
Fig. 12 is a perspective view similar to Fig. 8 according to a second embodiment of the invention;
Fig. 13 is a perspective view similar to Fig. 8 according to a third embodiment of the invention;
Fig. 14 is a perspective view similar to Fig. 8 according to a fourth embodiment of the invention;
Fig. 15 is a perspective view similar to Fig. 8 according to a fifth embodiment of the invention;

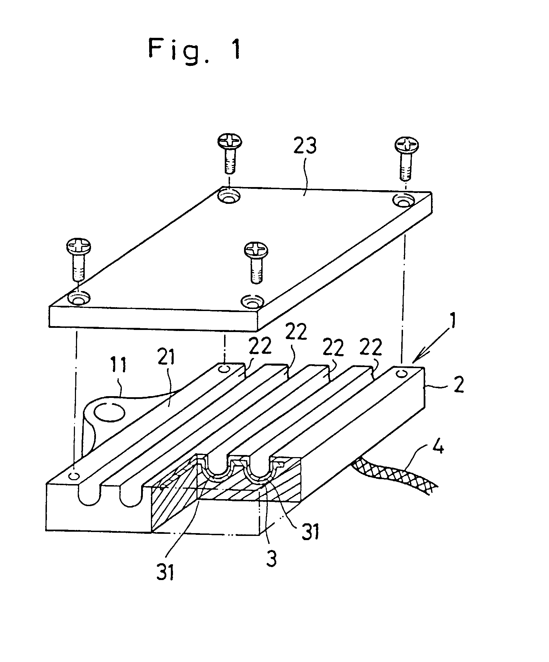

Referring to Fig. 1, this shows a spark plug voltage probe device 1 in an internal combustion engine. This is not in accordance with the present invention but is useful for understanding it. An insulator base 2 has a rectangular upper surface 21 on which a plurality of grooves 22 are provided at regular intervals in a longitudinal direction. Each of the grooves 22 is U-shaped in section. Each diameter of the grooves 22 corresponds to that of spark plug cables (HC), and the number of the grooves 22 corresponds to that of cylinders of the internal combustion engine. Along the grooves 22, an electrode plate 3 is embedded in the insulator base 2. The electrode plate 3 is in the form of a corrugated configuration which has channels 31 corresponding to the grooves 22 of the insulator base 2. The electrode plate 3 is embedded in the insulator base 2 at the time when the insulator base 2 is formed by means of an injection mould, and electrode plate 3 is electrically connected to a microcomputer as described hereinafter. An anchor block 11 is moulded at a side wall of the insulator base 2.

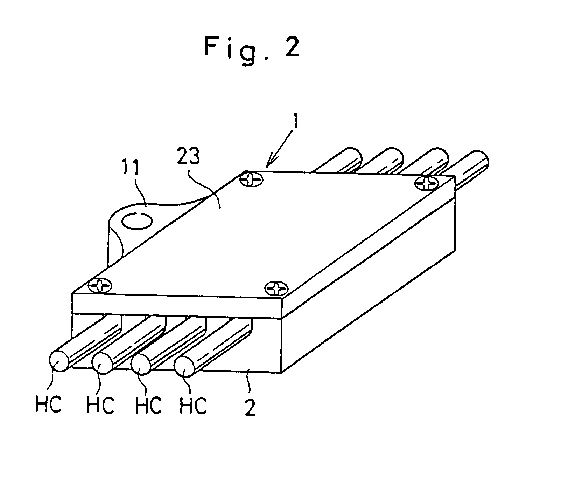

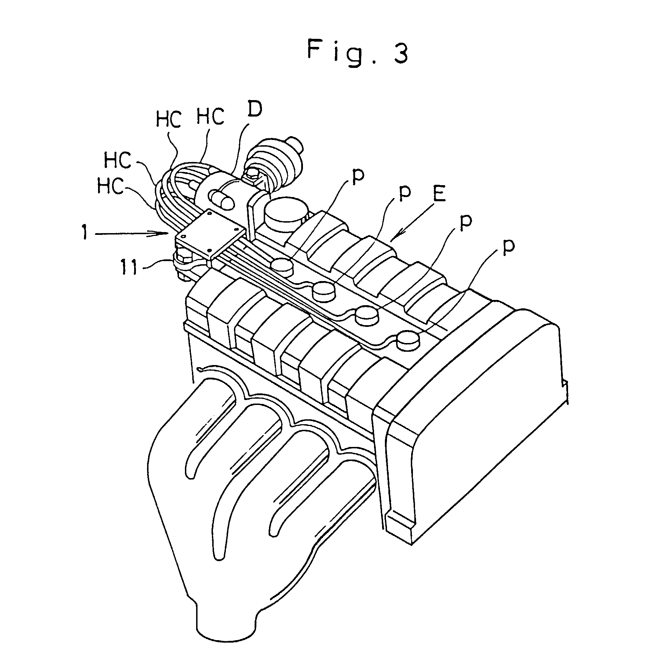

In each of the grooves 22, a cable (HC) is located to form a static capacitance (e.g. 1 pF) between the electrode plate 3 and the cables (HC) as shown in Figure 2. On the upper surface 21 of the insulator base 2, a lid 23 is placed to secure each of the cables (HC) against removal. Then the spark plug voltage probe device 1 is mounted on an internal combustion engine (E) by securing the anchor block 11 to a cylinder head of the internal combustion engine (E), and collects the cables (HC) to introduce the to a distributor (D) as shown in Fig. 3.

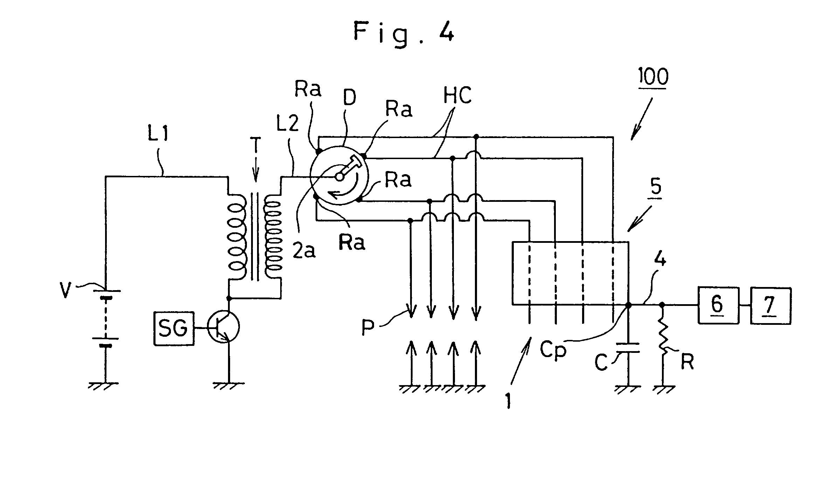

Fig. 4 shows an ignition system 100 which is incorporated into the internal combustion engine (E). The ignition system has an ignition coil (T) having a primary coil (L1) and a secondary coil (L2). In series with the primary coil (L1), a vehicular battery cell (V) and a signal generator (SG) are connected. Each of the cables (HC) has one end electrically connected to the secondary coil (L2) through a rotor 2a of the distributor (D) which integrally incorporates a contact breaker (not shown) and has e.g. four stationary segments (Ra). To each of the stationary segments (Ra), a free end of the rotor 2a approaches to make a series gap with the corresponding segments (Ra) during the rotary movement of the rotor 2a. To each of the four stationary segments (Ra), a spark plug (P) is electrically connected by way of the corresponding cables (HC). Each of the spark plugs (P) is electrically connected to ground so that the secondary coil (L2) energizes each of the spark plugs (P) by way of the cables (HC), the rotor 2a and the stationary segment (Ra) of the distributor (D).

A common point (Cp) between the electrode plate 3 and a lead wire 4, is grounded by way of a capacitor C (3000 pF) to form a voltage divider circuit 5. In parallel with the capacitor (C), an electrical resistor R (e.g. 3 MΩ) is connected to form a discharge circuit for the capacitor (C). The voltage divider circuit 5 divides a spark plug voltage by the order of 3000. The RC time constant is 9 milliseconds, thus making it possible to observe a relatively slow change in the spark plug voltage.

Meanwhile, the lead wire 4 is connected to a spark plug voltage waveform detector circuit 6. The circuit 6 is connected to a distinction circuit (microcomputer) 7 which analyses a burning condition in the internal combustion engine (E) on the basis of the waveform outputted from the circuit 6 as described hereinafter.

The spark plug voltage waveform detector circuit 6 analyses a divided voltage waveform generated from the voltage divider circuit 5, and compares the characteristics of the divided voltage waveform with data determined by experiment.

The divided voltage waveform is analogous to that of the spark plug voltage, and changes depending upon the case in which an air-fuel mixture is normally ignited, and the case in which the air-fuel mixture is not ignited although a spark is established by the spark plug (P). The divided voltage waveform also changes depending upon the smoking of the spark plug (P), deterioration of the ignition coil (T) and a shortage of the vehicular battery cell (V).

Analysis of the divided voltage waveform makes it possible to distinguish normal ignition from accidental misfire and misspark.

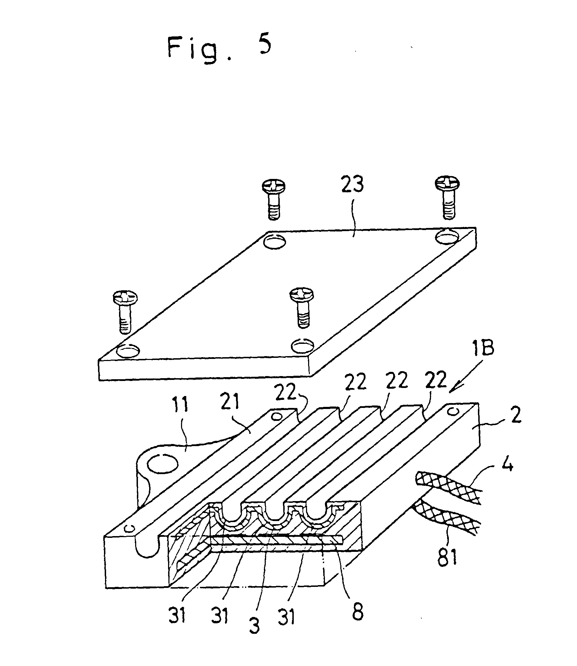

Fig. 5 shows a second non-embodiment of the invention in which a spark plug voltage probe device 1B has an electrical shield sheet 8 embedded in the insulator base 2 of the first non-embodiment, located under the electrode plate 3. The electrical shield sheet 8 is connected to the internal combustion engine (E) by way of a ground wire 81.

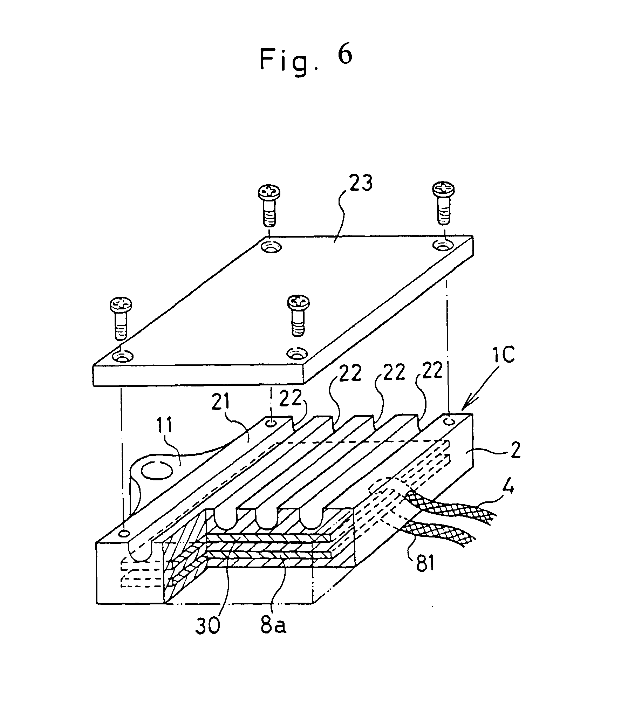

Fig. 6 shows a third non-embodiment of the invention in which a spark plug voltage probe device 1C has an electrical shield sheet 8a embedded in the insulator base 2, located under the electrode plate 30. The electrical shield sheet 8a is connected to the internal combustion engine (E) by way of the ground wire 81. It is observed that the electrical shield sheet may be in the form of meshes or a layer.

With the use of the electrical shield sheet, it is possible to prevent capacitive variation between the electrode plate and the cables when some metallic conductor is present at the periphery of the spark plug voltage probe device. This enables precise detection of the voltage waveform from the voltage divider circuit.

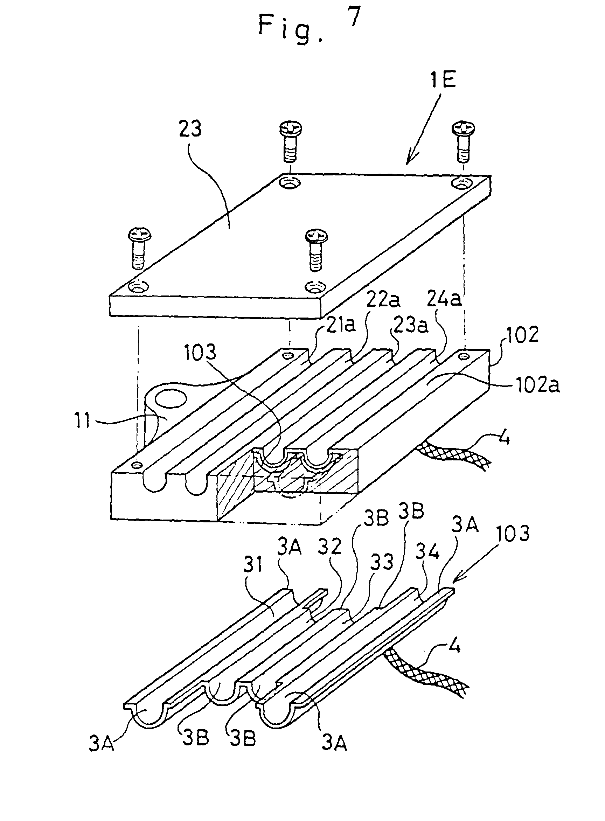

Fig. 7 shows a fourth non-embodiment of the invention in which a spark plug voltage probe device 1E has a rectangular insulator base 102, upper surface 102a of which has grooves 21a ∼ 24a at regular intervals in a longitudinal direction. Along the grooves 21a ∼ 24a, an electrode plate 103 is embedded in the insulator base 102 to form a static capacitance between the electrode plate 103 and spark plug cables 41 ∼ 44 which are liquid-tightly placed in the corresponding grooves 21a ∼ 24a by way of an adhesive. The electrode plate 103 is in the form of corrugated configuration which has channels 31 ∼ 34 corresponding to the grooves 21a ∼ 24a of insulator base 102.

Among the channels 31 ∼ 34, longitudinal ends 3A, 3A of the outside channels 31, 34 extend beyond longitudinal ends 3B, 3B of the inside channels 32, 33 respectively. Thereby, each length of outside channels 31, 34 is greater than that of the inside channels 32, 33 so as to form substantially an H-shaped configuration as a whole.

This enables the device to compensate effectively for a capacitive shortage so that he static capacitance between the cables 41, 44 and the outside channels 31, 34 is substantially equal to the static capacitance between the cables 42, 43 and the inside channels 32, 33 thus making it possible to avoid differences among the static capacitances between each of the cables and the corresponding channels.

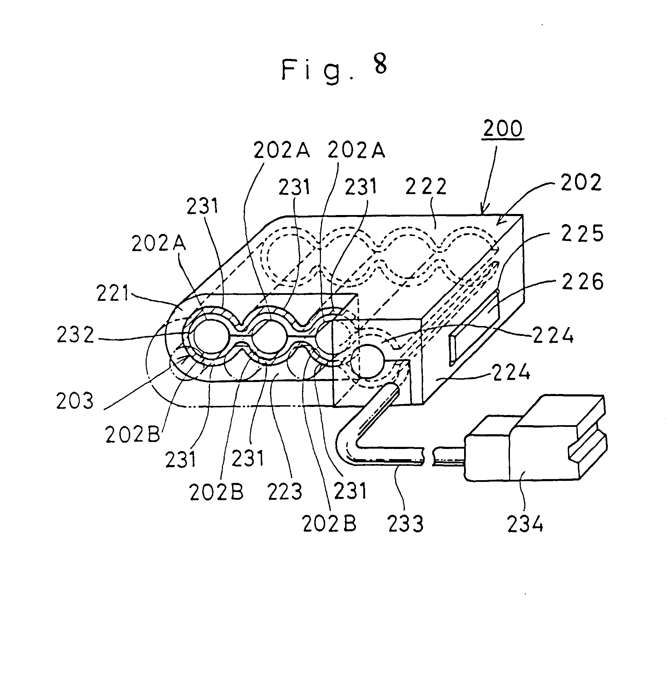

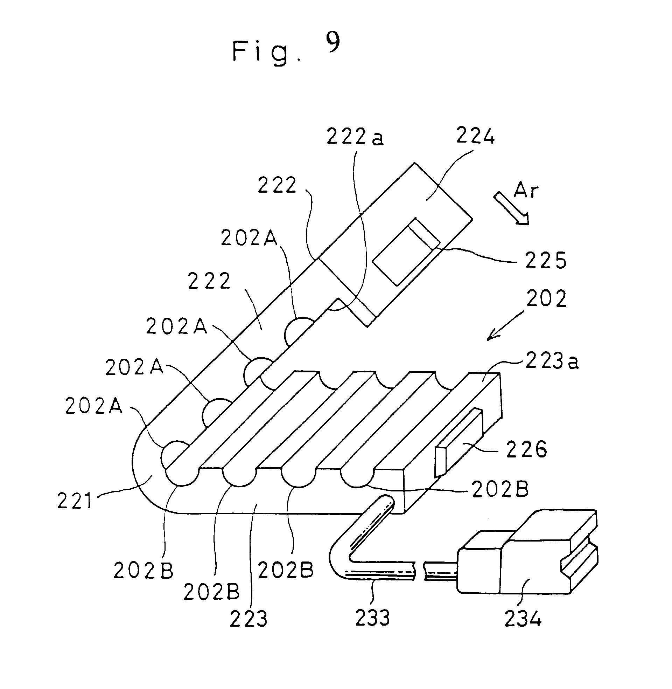

Referring to Figs. 8 and 9, which show a first embodiment of the invention, a spark plug voltage probe device 200 has an insulator base 202 including an upper half 222 and a lower half 223 which are integrally connected by a flexible portion 221. On a lower surface 222a of the upper half 222, grooves 202A are provided at regular intervals. On an upper surface 223a of the lower half 223, grooves 202B are provided which correspond to the grooves 202A. In the insulator base 202, an electrode plate 232 is embedded along the grooves 202A, 202B. The electrode plate 232 is in the form of a corrugated configuration which has channels 231 in correspondence to the grooves 202A, 202B. The electrode plate 232 is connected to a connector 234 by way of a lead wire 233.

From an open position in which the upper half 222 is away from the lower half 223 as shown in Fig. 9, the upper half 222 is folded around the flexible portion 221 in the direction of an arrow (Ar) to occupy a closed position in which the upper half 222 is snugly placed on the lower half 223 as shown in Fig. 8. One end of the upper half 222 integrally carries an elastic plate 224 having an opening 225 which admits a protrusion 226 provided on one end of the lower half 223 to latch the upper half 222 in the closed position.

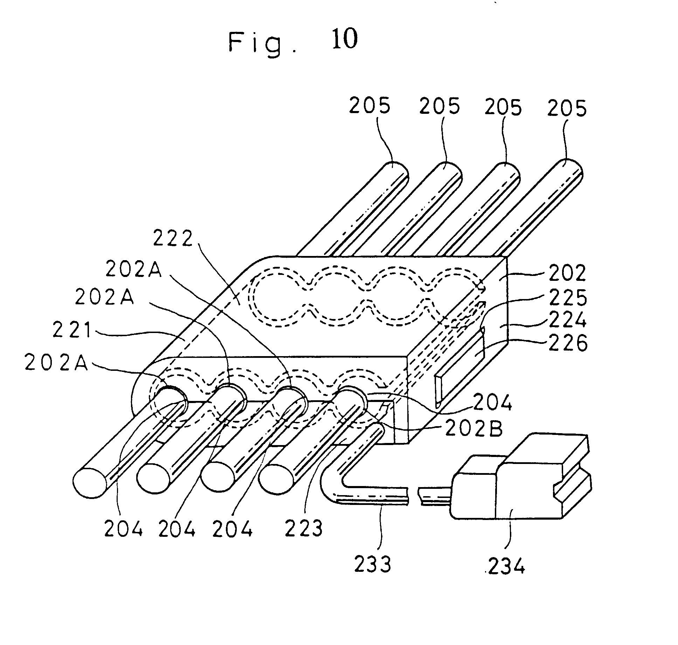

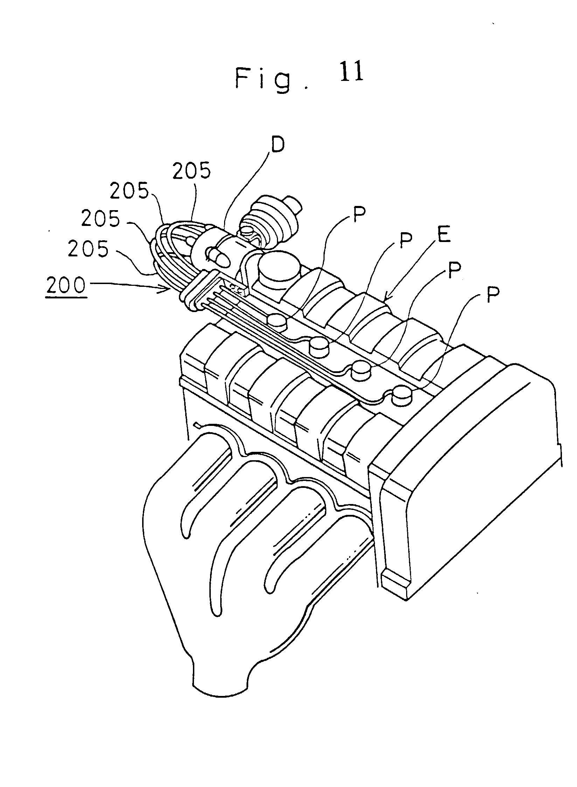

During the process of folding the upper half 222 from the open position to the closed position, spark plug cables 205 are liquid-tightly placed in the corresponding grooves 202A, 202B by way of an adhesive filler 204 as shown in Fig. 10. Then the spark plug voltage probe device 200 is mounted on the internal combustion engine (E) to collect the cables 205 from the spark plugs (P) so as to introduce the cables 205 to the distributor (D), as shown in Fig. 11.

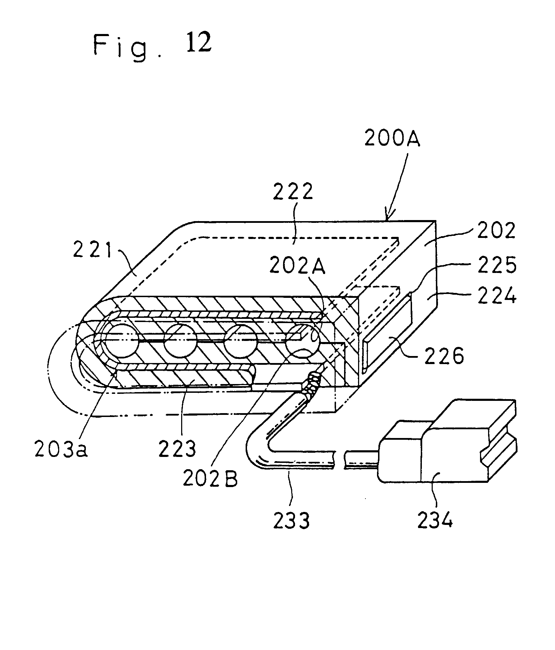

Fig. 12 shows a second embodiment of the invention in which a spark plug voltage probe device 200A has a flat-shaped electrode plate 203a instead of the corrugated configuration.

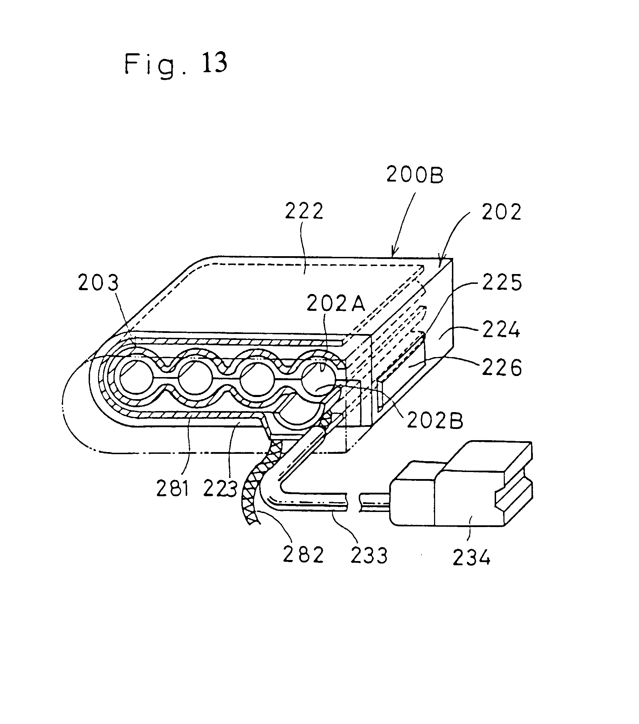

Fig. 13 shows a third embodiment of the invention in which a spark plug voltage probe device 200B has an electrical shield sheet 281 embedded in the insulator base 202 around an electrode plate 203. The shield sheet 281 is connected to the internal combustion engine (E) by way of a ground wire 282.

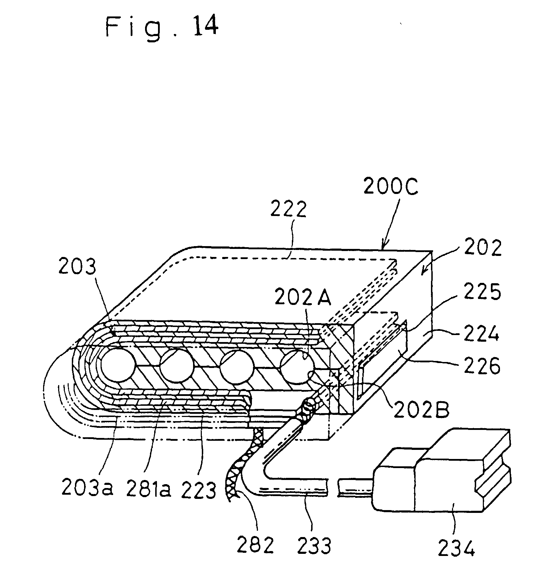

Fig. 14 shows a fourth embodiment of the invention in which a spark plug voltage probe device 200C has an electrical shield sheet 281a embedded in an insulator base 202 around the electrode plate 203a.

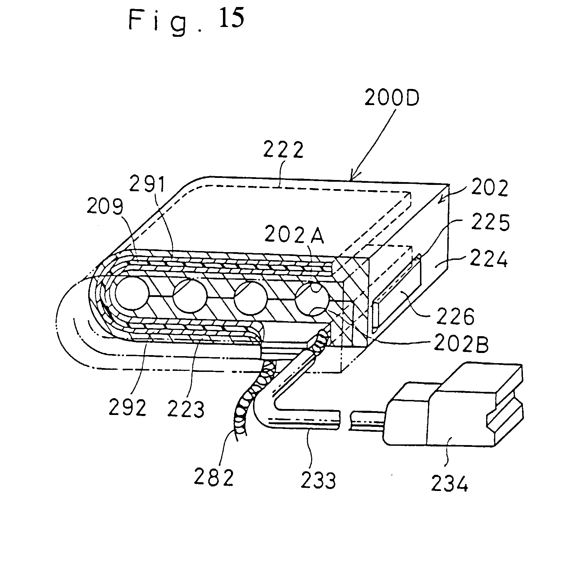

Fig. 15 shows a fifth embodiment of the invention in which a spark plug voltage probe device 200D has an insulator sheet 209 made of a polyimide resin, for example. An electrode layer 291 is provided on an inner surface of the insulator sheet 209, and an electrical shield layer 292 is provided on an outer surface of the insulator sheet 209. It is observed that the electrode layer 291 and the shield layer 292 may be of electrically conductive rubber or a metallic net of appropriate inch meshes.

## Claims

1. A spark plug voltage probe device (200;200A;200B;200C;200D) for attachment to an internal combustion engine (E) and for detecting a voltage applied to spark plugs (P) installed in the internal combustion engine by way of corresponding cables (205), the device comprising:
an insulator base (202) having a plurality of grooves (202A, 202B) in which the corresponding cables are to be placed;
an electrode layer (203;203a,232;291) embedded in the insulator base along the grooves to form a static capacitance between the electrode layer and placed cables when the voltage is supplied across the spark plugs;
a lead wire (233) provided for electrically connecting the electrode layer to a microcomputer so as to analyse the burning condition in the internal combustion engine on the basis of the voltage applied to each of the spark plugs; characterised in that
said insulator base includes an upper half (222) and a lower half (223) which are integrally connected by means of a pivot portion (221), both said upper half and said lower half providing said grooves for holding said corresponding cables when the two halves are folded together about the pivot portion; in that
the upper half has an opening (225) which admits an entry of a protrusion (226) which is provided on the lower half to maintain the upper half and the lower half in a folded position; and in that
said electrode layer (203;203a;232) is embedded in both said upper and lower halves.

2. A device as recited in claim 1, wherein an adhesive filler (204) is provided between the upper half (222) and the lower half (223) of the insulator base (202) for preventing the entry of water into the insulator base.

3. A device (200B;200C;200D) as recited in claim 1 or 2, further comprising an electrical shield layer 281;281a;292) embedded in the insulator base (202) in the proximity of the electrode layer (203;203a;291), and located at a side of the electrode layer remote from the grooves (202A,202B) so as to shield the electrode layer electrically.

4. A device as recited in any one of claims 1 to 3 wherein the two side portions of the electrode layer are of greater length in the direction of the grooves than the central portion between them is, to form substantially an H-shaped configuration in plan view, whereby the static capacitance has an even distribution.

5. A device (200A;200C;200D) as recited in any one of claims 1 to 4, wherein said electrode layer (203a,291) is flat.

6. A device (200;200B) as recited in any one of claims 1 to 4 wherein said electrode layer (203;232) is corrugated in section.

## Patentansprüche

1. Zündkerzen-Spannungsmeßfühlervorrichtung (200; 200A; 200B; 200C; 200D) zur Anbringung an einem Verbrennungsmotor (E) und zur Feststellung einer an im Verbrennungsmotor mittels entsprechender Kabel (205) installierten Zündkerzen (P) angelegten Spannung, wobei die Vorrichtung folgendes umfaßt:
- ein Trennschaltergrundteil (202) mit mehreren Auskehlungen (202A, 202B), in die die entsprechenden Kabel zu legen sind;
- eine in das Trennschaltergrundteil entlang der Auskehlungen eingebettete Elektrodenschicht (203; 203a, 232; 291) zur Ausbildung einer statischen Kapazität zwischen der Elektrodenschicht und den eingesetzten Kabeln bei Versorgung mit Spannung über die Zündkerzen;
- einen für die elektrische Verbindung der Elektrodenschicht mit einem Mikrocomputer vorgesehenen Zuleitungsdraht (233) zur Analyse des Verbrennungszustands in dem Verbrennungsmotor auf der Grundlage der an jeder der Zündkerzen angelegten Spannung;
dadurch gekennzeichnet, daß
- das Trennschaltergrundteil eine obere Hälfte (222) und eine untere Hälfte (223) umfaßt, die mittels eines Schwenkteils (221) integral verbunden sind, wobei die obere Hälfte und die untere Hälfte bei Zusammenklappen der zwei Hälften um das Schwenkteil Auskehlungen zum Halten der entsprechenden Kabel vorsehen;
- die obere Hälfte eine Öffnung (225) aufweist, die ein Eintreten eines Vorsprungs (226) erlaubt, welcher auf der unteren Hälfte vorgesehen ist, um die obere Hälfte und die untere Hälfte in einer geklappten Position zu halten;
- die Elektrodenschicht (203; 203a; 232) sowohl in die obere als auch in die untere Hälfte eingebettet ist.

2. Vorrichtung nach Anspruch 1, dadurch gekennzeichnet, daß ein Klebfüllstoff (204) zwischen der oberen Hälfte (222) und der unteren Hälfte (223) des Trennschaltergrundteils (202) vorgesehen ist, um das Eindringen von Wasser in das Trennschaltergrundteil zu verhindern.

3. Vorrichtung (200B; 200C; 200D) nach Anspruch 1 oder 2, welche weiterhin eine in dem Trennschaltergrundteil (202) in der Nähe der Elektrodenschicht (203; 203a; 291) eingebettete und an einer Seite der Elektrodenschicht fern der Auskehlungen (202A, 202B) angeordnete elektrische Abschirmschicht (281; 281a; 292) umfaßt, um die Elektrodenschicht elektrisch abzuschirmen.

4. Vorrichtung nach einem der Ansprüche 1 bis 3, dadurch gekennzeichnet, daß die zwei Seitenabschnitte der Elektrodenschicht in Richtung der Auskehlungen eine größere Länge als der mittlere Abschnitt zwischen ihnen aufweisen, um in Draufsicht eine im wesentlichen H-förmige Konfiguration auszubilden, wodurch die statische Kapazität eine gleichmäßige Verteilung aufweist.

5. Vorrichtung (200A; 200C; 200D) nach einem der Ansprüche 1 bis 4, dadurch gekennzeichnet, daß die Elektrodenschicht (203a, 291) flach ist.

6. Vorrichtung (200; 200B) nach einem der Ansprüche 1 bis 4, dadurch gekennzeichnet, daß die Elektrodenschicht (203; 232) im Schnitt gewellt ist.

## Revendications

1. Dispositif capteur de tension d'une bougie d'allumage (200 ; 200A ; 200B ; 200C ; 200D) destiné à être fixé sur un moteur à combustion interne (E) et à détecter une tension appliquée à des bougies d'allumage (P), installées dans le moteur à combustion interne, par l'intermédiaire de câbles correspondants (205), le dispositif comportant :
une base isolante (202) ayant plusieurs gorges (202A, 202B) dans lesquelles les câbles correspondants doivent être placés,
une couche d'électrode (203 ; 203a, 232 ; 291) noyée dans la base isolante le long des gorges pour former une capacité statique entre la couche d'électrode et des câbles placés lorsque la tension est envoyée aux bougies d'allumage,
un fil conducteur (233) agencé pour connecter électriquement la couche d'électrode à un microcalculateur de manière à analyser les conditions de combustion dans le moteur à combustion interne sur la base de la tension appliquée à chacune des bougies d'allumage, caractérisé en ce que
ladite base isolante comporte une moitié supérieure (222) et une moitié inférieure (223) qui sont reliées sous forme d'un tout par l'intermédiaire d'une partie de pivotement (221), les deux moitiés supérieure et inférieure fournissant lesdites gorges destinées à retenir lesdits câbles correspondants lorsque les deux moitiés sont repliées l'une vers l'autre autour de la partie de pivotement, et en ce que
la moitié supérieure a une ouverture (225) qui admet l'entrée d'une saillie (226) qui est agencée sur la moitié inférieure pour maintenir la moitié supérieure et la moitié inférieure dans un état replié, et en ce que
ladite couche d'électrode (203 ; 203a ; 232) est noyée dans les deux moitiés supérieure et inférieure.

2. Dispositif selon la revendication 1, dans lequel une charge d'adhésif (204) est disposée entre la moitié supérieure (222) et la moitié inférieure (223) de la base isolante (202) pour empêcher la pénétration d'eau dans la base isolante.

3. Dispositif (200B ; 200C ; 200D) selon la revendication 1 ou 2, comportant de plus une couche formant blindage électrique (281 ; 281a ; 292) noyée dans la base isolante (202) à proximité de la couche d'électrode (203 ; 203a ; 291), et située au niveau du côté de la couche d'électrode éloigné des gorges (202A, 202B) de manière à blinder électriquement la couche d'électrode.

4. Dispositif selon l'une quelconque des revendications 1 à 3, dans lequel les deux parties latérales de la couche d'électrode ont une longueur plus grande dans la direction des gorges que la partie centrale située entre celles-ci, pour former une configuration ayant sensiblement la forme d'un H en vue de dessus, de sorte que la capacité statique a une répartition régulière.

5. Dispositif (200A ; 200C ; 200D) selon l'une quelconque des revendications 1 à 4, dans lequel ladite couche d'électrode (203a, 291) est plate.

6. Dispositif (200 ; 200B) selon l'une quelconque des revendications 1 à 4, dans lequel ladite couche d'électrode (203 ; 232) a une section transversale ondulée.
